# EUROPEAN PATENT APPLICATION

(11) **EP 4 362 079 A1**
(43) Date of publication of application: **01.05.2024**
(21) Application number: 22866399.3
(22) Date of filing: 23.08.2022
(51) Int. Cl.: H01L 23/31

(54) **CHIP PACKAGING STRUCTURE AND PREPARATION METHOD THEREFOR, AND ELECTRONIC DEVICE**

(30) Priority: 10.09.2021 CN 202111063937
(71) Applicant: Huawei Technologies Co., Ltd., Shenzhen, Guangdong 518129 (CN)
(72) Inventor: ZHENG, Yonggang, Shenzhen, Guangdong 518129 (CN); JIANG, Ran, Shenzhen, Guangdong 518129 (CN); TANG, Zikai, Shenzhen, Guangdong 518129 (CN); LI, Yanghua, Shenzhen, Guangdong 518129 (CN); HUANG, Shujun, Shenzhen, Guangdong 518129 (CN)
(74) Representative: Maiwald GmbH
(86) International application number: PCT/CN2022/114108
(87) International publication number: WO 2023/035929

(57) **Abstract**

This application discloses a chip package structure, a production method for a chip package structure, and an electronic device. The chip package structure includes: a first connection layer having an upper surface and a lower surface that are opposite to each other, a die disposed on the upper surface of the first connection layer, a first conduction structure disposed on an upper surface of the die, a first plastic package layer covering the die and the first conduction structure, and a rewiring layer disposed on the first plastic package layer. At least a part of the first conduction structure is exposed from an upper surface of the first plastic package layer. The rewiring layer is coupled to the first conduction structure. A signal of the die is directly led out through the first conduction structure and the rewiring layer. This saves space, reduces a wiring length and interconnection inductance, and implements a low loss and an efficient interconnection of signals between dies. A signal interconnection between the dies is implemented through the rewiring layer, and based on an impedance value of the die, circuit wiring matching the impedance value may be disposed at the rewiring layer. This does not need components used for coupling impedance, such as a capacitor, saves space, and reduces design complexity.

## Description

### CROSS-REFERENCE TO RELATED APPLICATION

This application claims priority to Chinese Patent Application No. 202111063937.X, filed with the China National Intellectual Property Administration on September 10, 2021 and entitled "CHIP PACKAGE STRUCTURE, PRODUCTION METHOD FOR CHIP PACKAGE STRUCTURE, AND ELECTRONIC DEVICE", which is incorporated herein by reference in its entirety.

### TECHNICAL FIELD

This application relates to the field of chip packaging technologies, and in particular, to a chip package structure, a production method for a chip package structure, and an electronic device.

### BACKGROUND

With rapid popularization of electronic devices and vigorous development of the electronic device market, electronic products are increasingly required to evolve toward miniaturization and thinness while having high performance, a plurality of functions, high reliability, and convenience. Such a requirement requires chip package to be better, lighter, and thinner, and have higher package density, better electrical performance and thermal performance, higher reliability, and higher cost-effectiveness.

A 5G power amplifier module continuously evolves toward a high frequency, high efficiency, and miniaturization. An existing package architecture using wire bonding is limited by a diameter of a wire (wire) and wiring. As a result, interconnection inductance in a chip package structure is relatively large. In addition, the wire in the chip package structure is relatively long. As a result, an insertion loss is large. This restricts evolution of a product toward miniaturization and high performance.

### SUMMARY

This application provides a chip package structure, a production method for a chip package structure, and an electronic device, to reduce interconnection inductance in the chip package structure.

According to a first aspect, this application provides a chip package structure, including: a first connection layer, having an upper surface and a lower surface that are opposite to each other; a die, disposed on the upper surface of the first connection layer; a first conduction structure, disposed on an upper surface of the die; a first plastic package layer, covering the die and the first conduction structure; and a rewiring layer, disposed on the first plastic package layer. The die is coupled to the upper surface of the first connection layer. The first conduction structure is coupled to the die. At least a part of the first conduction structure is exposed from an upper surface of the first plastic package layer, that is, the upper surface of the first plastic package layer does not cover an upper end of the first conduction structure. The rewiring layer is coupled to the first conduction structure.

In the chip package structure provided by embodiments of this application, a signal of the die is directly led out through the first conduction structure and the rewiring layer. This saves space, reduces a wiring length and interconnection inductance, and implements a low loss and an efficient interconnection of signals between dies. In addition, a signal interconnection between the dies is implemented through the rewiring layer, and based on an impedance value of the die, circuit wiring matching the impedance value may be disposed at the rewiring layer. This does not need components used for coupling impedance, such as a capacitor, in the chip package structure, saves space, and reduces design complexity.

In a possible implementation of this application, the rewiring layer may specifically include a patterned circuit layer and a first protection layer configured to protect the patterned circuit layer. An impedance value of the patterned circuit layer may match an impedance value of a die coupled to the patterned circuit layer through the first conduction structure 3. Matching between impedance values means that, for a preset impedance value of different dies, an impedance value that is approximately the same as the preset impedance value or in a tolerance range is specified for the patterned circuit layer. The impedance value may include parameters such as an inductive reactance value, a capacitive reactance value, and a resistance value. Specifically, the impedance value of the patterned circuit layer may be adjusted to match the impedance value of the coupled die by adjusting parameters such as a thickness of the patterned circuit layer and an area of the patterned circuit layer. The first protection layer may be green oil or a plastic package material. A thickness of the first protection layer is 10 micrometers to 40 micrometers.

In a possible implementation of this application, to implement high-density integration of a module, a first conduction structure with a high thickness-to-diameter ratio (pillar) may be disposed. The high thickness-to-diameter ratio means that a ratio of a thickness of the first conduction structure to a diameter of the first conduction structure is 2:1 or above. To be specific, in the chip package structure, the thickness of at least some first conduction structures is greater than or equal to twice the diameter of the first conduction structures. Based on a requirement of the chip package structure, the thickness-to-diameter ratio of some formed first conduction structures may reach 10:1. This breaks through an electroplating capability limitation that a thickness ratio of a blind via formed by laser needs to be less than or equal to 1:1, and resolves a risk that a thin plating layer (less than 2 micrometers) of a die in a power amplifier module may be penetrated by laser. For example, for a plurality of dies with different thicknesses, a first conduction structure with a relatively large thickness-to-diameter ratio may be formed on a die with a relatively small thickness. A first conduction structure with a relatively small thickness-to-diameter ratio may be formed on a die with a relatively large thickness. It should be noted that the diameter of the first conduction structure is a diameter of any horizontal cross section of the first conduction structure (if the horizontal cross section is circular) or a width of any horizontal cross section of the first conduction structure (if the horizontal cross section is polygonal).

In a possible implementation of this application, there are usually a plurality of first conduction structures in the chip package structure. Any first conduction structure may be specifically a plurality of solder balls that are stacked in a vertical direction. During production, first conduction structures with different heights may be formed on a die by stacking solder balls by wire bonding. For example, one to five solder balls are stacked to form a first conduction structure with a thickness between 50 micrometers and 250 micrometers. The thickness-to-diameter ratio of the formed first conduction structure may be controlled by controlling a quantity of stacked solder balls. Generally, a relatively small quantity of solder balls may be stacked on the die with the relatively large thickness. A relatively large quantity of solder balls may be stacked on the die with the relatively small thickness. It should be noted that the thickness-to-diameter ratio of the first conduction structure that includes the plurality of solder balls that are stacked is a ratio of a maximum thickness obtained after the solder balls are stacked to a maximum diameter of the solder balls.

In another possible implementation of this application, any first conduction structure may alternatively be at least one wire. During production, a wire may be formed on a die by wire bonding. The wire may be specifically a metal wire of 0.6 mil to 3.0 mil. The thickness-to-diameter ratio of the first conduction structure formed by the wire is usually greater than 2: 1. It should be noted that the thickness-to-diameter ratio of the first conduction structure including at least one wire is a ratio of a maximum length of all wires to a maximum diameter of all the wires, or a ratio of the maximum length of all the wires to a sum of diameters of all the wires. The first conduction structure 3 may be formed on different dies in different manners or in a same manner. This is not limited herein.

In a possible implementation of this application, one first conduction structure may include at least one pair of wires. During production, two ends of one initial wire may be coupled to a same die, that is, both ends of the initial wire are fastened to the same die. In this case, the initial wire forms an arc shape on the die. In the first conduction structure finally formed by plastic packaging and polishing, the initial wire is divided into a pair of wires, and a top of the arc shape of the initial wire is broken and respectively used as exposed ends of two wires. That both ends of the initial wire are fastened to one die helps stabilize a shape of the first conduction structure when the first plastic package layer is subsequently formed. Alternatively, in another embodiment of this application, only one end of the initial wire may be coupled to the die. The other end is suspended as an exposed end of the first conduction structure.

In a possible implementation of this application, the first connection layer may be made of a metal-based or metal-inorganic composite material. The upper surface of the first connection layer may have a first pin. The first pin has a heat sink and current flow function. The die may be specifically coupled to the first pin. Specifically, the die may be coupled to the first pin through a second connection layer. During production, the die may be bonded to the first pin through the second connection layer, and sintered and fastened by a sintering process. Alternatively, the die may be directly coupled to the first pin. During production, a plating layer of the die may be directly fused and fastened to the first pin by a eutectic soldering process instead of the sintering process.

In a possible implementation of this application, after the first conduction structure is formed on the die, plastic packaging may be performed on the die and the first conduction structure, to form the first plastic package layer. This ensures that the die and the first conduction structure form embedded structures in the first plastic package layer. Then, the upper surface of the first plastic package layer may be polished by using a high-precision polishing device, to expose an end of the first conduction structure. The upper surface of the first plastic package layer formed by this process is flush with the exposed end of the first conduction structure. Alternatively, the upper surface of the first plastic package layer may be polished by using a high-precision polishing device, and then an end of the first conduction structure is exposed by laser opening. The first plastic package layer formed by this process has through grooves that expose the end of the first conduction structure. The rewiring layer has protruding parts that are in a one-to-one correspondence with the through grooves. The protruding part may be located in the through groove, so that the first conduction structure is coupled. Alternatively, an end of the first conduction structure may be exposed directly by laser opening. The first plastic package layer formed by this process has through grooves that expose the end of the first conduction structure. The rewiring layer has protruding parts that are in a one-to-one correspondence with the through grooves. The protruding part may be located in the through groove, so that the first conduction structure is coupled.

In a possible implementation of this application, a plurality of dies may be fastened to the first connection layer. A thickness of each die is not limited. Dies with different thicknesses may be coupled to the first connection layer, that is, at least two dies have different thicknesses. In this case, the finally formed chip package structure may be compatible with dies of various sizes. The thickness of the die may be 80 micrometers to 200 micrometers. Then, the first conduction structure is formed on each of different dies. After plastic packaging is performed on the die and the first conduction structure as a whole to form the first plastic package layer, an end that is of the first conduction structure and that is away from the die is exposed by polishing (or by laser opening, or by polishing and laser opening). Then, the rewiring layer coupled to the first conduction structure is produced, to implement a signal interconnection between the dies at the rewiring layer.

In a possible implementation of this application, when the chip package structure is used in a flip package structure, a connection terminal may be further disposed on the rewiring layer. The connection terminal is configured to be coupled to an external circuit board. The connection terminal may be specifically soldering tin, a solder ball, a solderable plating layer, or a solderable connection column.

In a possible implementation of this application, to implement three dimensional stacking and high-density integration, the chip package structure may further include: a chip, disposed on the rewiring layer; a second conduction structure, disposed on the rewiring layer; a second plastic package layer, covering the chip and the second conduction structure; a third connection layer, disposed on the second plastic package layer; and a second protection layer, configured to protect the third connection layer. The second protection layer may be the green oil or the plastic package material. At least a part of the second conduction structure is exposed from an upper surface of the second plastic package layer. The third connection layer is coupled to the second conduction structure. A signal of the chip may be led out through the rewiring layer, the second conduction structure, and the third connection layer, to implement a vertical interconnection.

In a possible implementation of this application, the second conduction structure may be specifically a plurality of solder balls that are stacked in the vertical direction, or at least one wire, or a planted pin. Specifically, the stacked solder balls or the wire may be formed by wire bonding, and the planted pin is formed by soldering. To implement the high-density integration of the module, similar to the first conduction structure, a second conduction structure with a high thickness-to-diameter ratio may also be disposed.

In a possible implementation of this application, the chip, the second conduction structure, the second plastic package layer, the third connection layer, and the second protection layer may be considered to form a layer of stackup. The chip package structure may include at least one layer of stackup. Only one layer of stackup may be disposed in the chip package structure. When the chip package structure is used in the flip package structure, a connection terminal may be further disposed at the third connection layer. The connection terminal is configured to be coupled to the external circuit board. The connection terminal may be specifically the soldering tin, the solder ball, the solderable plating layer, or the solderable connection column. Alternatively, a plurality of layers of stackups may be disposed in the chip package structure. A chip in a stackup of a bottom layer is coupled to the rewiring layer. A chip in a stackup of another layer is coupled to a third connection layer in a stackup of a next layer. When the chip package structure is used in the flip package structure, a connection terminal may be further disposed at a third connection layer in a stackup of a top layer. The connection terminal is configured to be coupled to the external circuit board. The connection terminal may be specifically the soldering tin, the solder ball, the solderable plating layer, or the solderable connection column.

In a possible implementation of this application, to lead out a signal of the chip package structure from both sides, that is, to lead out the signal from a side of the lower surface of the first connection layer, the first connection layer may have a second pin. The second pin may also be referred to as an external pin. A third conduction structure may be disposed on the second pin. The third conduction structure and the first conduction structure may be simultaneously formed. The first plastic package layer covers the third conduction structure. At least a part of the third conduction structure is exposed from the upper surface of the first plastic package layer. In this case, the rewiring layer is coupled to the second pin of the first connection layer through the third conduction structure, and the signal of the die may flow to the lower surface of the first connection layer through the first conduction structure, the rewiring layer, the second conduction structure, and the first connection layer, and then led out.

In a possible implementation of this application, to implement the high-density integration of the module, similar to the first conduction structure, a third conduction structure with a high thickness-to-diameter ratio may be disposed. Based on the requirement of the chip package structure, the thickness-to-diameter ratio of the formed third conduction structure may reach 10: 1. This breaks through the electroplating capability limitation that the thickness ratio of the blind via formed by laser needs to be less than or equal to 1:1, and resolves the risk that the thin plating layer (less than 2 micrometers) in the power amplifier module may be penetrated by laser.

In a possible implementation of this application, after the first conduction structure is formed on the die and the third conduction structure is formed on the second pin, plastic packaging may be performed on the die, the first conduction structure, and the third conduction structure to form the first plastic package layer. This ensures that the die, the first conduction structure, and the third conduction structure simultaneously form embedded structures in the first plastic package layer. Then, the upper surface of the first plastic package layer may be polished by using the high-precision polishing device, to expose the end of the first conduction structure and an end of the third conduction structure. The upper surface of the first plastic package layer formed by this process is flush with the exposed end of the first conduction structure and the exposed end of the third conduction structure. Alternatively, the end of the first conduction structure and an end of the third conduction structure may be directly exposed by laser opening. The first plastic package layer formed by this process has through grooves that expose the end of the first conduction structure and the end of the third conduction structure. The rewiring layer has protruding parts that are in a one-to-one correspondence with the through grooves. The protruding part is located in the through groove. Alternatively, the upper surface of the first plastic package layer may be polished by using the high-precision polishing device, and then the end of the first conduction structure and an end of the third conduction structure are exposed by laser opening. The first plastic package layer formed by this process has through grooves that expose the end of the first conduction structure and the end of the third conduction structure. The rewiring layer has protruding parts that are in a one-to-one correspondence with the through grooves. The protruding part is located in the through groove. Alternatively, when the end of the first conduction structure is higher than an end of the third conduction structure, the upper surface of the first plastic package layer may be polished by using the high-precision polishing device until the end of the first conduction structure is exposed, and then the end of the third conduction structure is exposed by laser opening. The upper surface of the first plastic package layer formed by this process is flush with the exposed end of the first conduction structure. In addition, the first plastic package layer has through grooves that expose the end of the third conduction structure. The rewiring layer has protruding parts that are in a one-to-one correspondence with the through grooves. The protruding part is located in the through groove. When an end of the third conduction structure is higher than the end of the first conduction structure, the upper surface of the first plastic package layer may be polished by using the high-precision polishing device until the end of the third conduction structure is exposed, and then the end of the first conduction structure is exposed by laser opening. The upper surface of the first plastic package layer formed by this process is flush with the exposed end of the third conduction structure. In addition, the first plastic package layer has through grooves that expose the end of the first conduction structure. The rewiring layer has protruding parts that are in a one-to-one correspondence with the through grooves. The protruding part is located in the through groove.

In a possible implementation of this application, the third conduction structure may be specifically a plurality of solder balls that are stacked in the vertical direction, or at least one wire, or a planted pin. Specifically, the stacked solder balls or the wire may be formed on the second pin by wire bonding, or the planted pin is formed by soldering. An upper surface of the third conduction structure needs to be as flush as possible with an upper surface of the first conduction structure. To be specific, when the third conduction structure is formed, refer to a sum of thicknesses of the first conduction structure and the die.

In a possible implementation of this application, one third conduction structure may include at least one pair of wires. During production, two ends of one initial wire may be coupled to a same second pin, that is, both ends of the initial wire are fastened to the same second pin. In this case, the initial wire forms an arc shape on the second pin. In the third conduction structure finally formed by plastic packaging and polishing, the initial wire is divided into a pair of wires, and a top of the arc shape of the initial wire is broken and respectively used as exposed ends of two wires. That both ends of the initial wire are fastened to one second pin helps stabilize a shape of the third conduction structure when the first plastic package layer is subsequently formed. Alternatively, in another embodiment of this application, only one end of the initial wire may be coupled to the second pin. The other end is suspended as the exposed end of the third conduction structure.

According to a second aspect, this application provides a production method for a chip package structure, including the following steps: providing a first connection layer having an upper surface and a lower surface that are opposite to each other; coupling a die to the upper surface of the first connection layer; forming a first conduction structure on an upper surface of the die; performing plastic packaging on the die and the first conduction structure, to embed the die and the first conduction structure in a first plastic package layer; exposing an end of the first conduction structure from an upper surface of the first plastic package layer; and forming a rewiring layer on the first plastic package layer.

In a possible implementation of this application, the die may be bonded to the first connection layer through a second connection layer, and a sintering process is performed, to fasten the die to the first connection layer. Alternatively, the die may be fastened to the first connection layer by a eutectic soldering process.

In a possible implementation of this application, a plurality of solder balls that are stacked in a vertical direction may be formed on the die by a wire bonding process. Alternatively, a wire is formed on the upper surface of the die by a wire bonding process. One end of the wire is coupled to the die, or both ends of the wire are coupled to the die.

In a possible implementation of this application, the end of the first conduction structure may be exposed from the upper surface of the first plastic package layer by polishing. Alternatively, the end of the first conduction structure may be exposed from the upper surface of the first plastic package layer by laser opening.

In a possible implementation of this application, if the upper surface of the first connection layer has an external pin, when forming the first conduction structure on the die, the production method further includes: forming a third conduction structure on the external pin. When performing plastic packaging on the die and the first conduction structure, to embed the die and the first conduction structure in the first plastic package layer, the production method further includes: performing plastic packaging on the third conduction structure, to embed the third conduction structure in the first plastic package layer. When exposing the end of the first conduction structure from the upper surface of the first plastic package layer, the production method further includes: exposing an end of the third conduction structure from the upper surface of the plastic package layer.

In a possible implementation of this application, a plurality of solder balls that are stacked in the vertical direction may be formed on the external pin by the wire bonding process. Alternatively, a wire is formed on the external pin by the wire bonding process, where one end of the wire is coupled to the external pin, or both ends of the wire are coupled to the external pin. Alternatively, a planted pin is formed on the external pin by soldering.

In a possible implementation of this application, the end of the third conduction structure may be exposed from the upper surface of the first plastic package layer by polishing. Alternatively, the end of the third conduction structure is exposed from the upper surface of the first plastic package layer by laser opening.

In a possible implementation of this application, the production method may further include the following steps: fastening a chip on the rewiring layer; forming a second conduction structure on the rewiring layer; performing plastic packaging on the chip and the second conduction structure, to embed the chip and the second conduction structure in a second plastic package layer; exposing an end of the second conduction structure from an upper surface of the second plastic package layer; and forming a third connection layer and a second protection layer on the second plastic package layer.

In a possible implementation of this application, a plurality of solder balls that are stacked in the vertical direction may be formed on the rewiring layer by the wire bonding process. Alternatively, a wire is formed on the rewiring layer by the wire bonding process, where one end of the wire is coupled to the rewiring layer, or both ends of the wire are coupled to the rewiring layer. Alternatively, a planted pin is formed on the rewiring layer by soldering.

According to a third aspect, this application provides an electronic device, including a circuit board and the chip package structure according to the first aspect or the chip package structure produced according to the second aspect that is electrically interconnected with the circuit board.

In a possible implementation of this application, when a third conduction structure is disposed in the chip package structure, the chip package structure may be a surface-mounted structure, and the circuit board may be disposed on a lower surface of a first connection layer in the chip package structure.

In a possible implementation of this application, when a connection terminal is disposed in the chip package structure, the chip package structure may be a flip structure, and the circuit board may alternatively be disposed on an upper surface of the chip package structure and coupled to the connection terminal. In this case, a heat dissipation structure may be further disposed on the lower surface of the first connection layer in the chip package structure.

### BRIEF DESCRIPTION OF DRAWINGS

FIG. 1 is a schematic diagram of a cross-sectional structure of an existing chip package structure;
FIG. 2 is a schematic diagram of a cross-sectional structure of another existing chip package structure;
FIG. 3a is a schematic diagram of a cross-sectional structure of a chip package structure according to an embodiment of this application;
FIG. 3b is a schematic diagram of a cross-sectional structure of a chip package structure according to another embodiment of this application;
FIG. 4 is a relationship between a test frequency band and an interconnection capacitance value of a chip package structure according to an embodiment of this application and a chip package structure shown in FIG. 1;
FIG. 5a is a schematic diagram of a cross-sectional structure of a chip package structure according to another embodiment of this application;
FIG. 5b is a schematic diagram of a cross-sectional structure of a chip package structure according to another embodiment of this application;
FIG. 6 is a schematic diagram of a cross-sectional structure of a chip package structure according to another embodiment of this application;
FIG. 7 is a schematic diagram of a cross-sectional structure of a chip package structure according to another embodiment of this application;
FIG. 8 is a schematic diagram of a cross-sectional structure of a chip package structure according to another embodiment of this application;
FIG. 9 is a schematic diagram of a cross-sectional structure of a chip package structure according to another embodiment of this application;
FIG. 10 is a schematic diagram of a cross-sectional structure of a chip package structure according to another embodiment of this application;
FIG. 11 is a schematic diagram of a cross-sectional structure of a chip package structure according to another embodiment of this application;
FIG. 12 is a schematic diagram of a cross-sectional structure of a chip package structure according to another embodiment of this application;
FIG. 13 is a schematic diagram of a cross-sectional structure of a chip package structure according to another embodiment of this application;
FIG. 14 is a schematic flowchart of a production method for a chip package structure according to an embodiment of this application;
FIG. 15 is a schematic diagram of a cross-sectional structure of an electronic device according to an embodiment of this application; and
FIG. 16 is a schematic diagram of a cross-sectional structure of an electronic device according to another embodiment of this application.

### Reference numerals:

01: wire; 02: plastic package layer; 03: blind via; 1: first connection layer; 2: die; 3: first conduction structure; 4: first plastic package layer; 5: rewiring layer; 51: patterned circuit layer; 52: first protection layer; 6: second connection layer; 7: connection terminal; 8: chip; 9: second conduction structure; 10: second plastic package layer; 11: third connection layer; 111: second protection layer; 12: second pin; 13: third conduction structure; 14: circuit board; 15: heat dissipation structure.

### DESCRIPTION OF EMBODIMENTS

To make the objectives, technical solutions, and advantages of this application clearer, the following further describes this application in detail with reference to the accompanying drawings.

Terms used in the following embodiments are only intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise specifically emphasized in another manner. The terms "include", "comprise", and "have", and variants thereof all mean "include but are not limited to", unless otherwise specifically emphasized in another manner.

In addition, identical reference numerals in the accompanying drawings denote identical or similar structures. Therefore, repeated description thereof is omitted. Expressions of positions and directions in this application are described by using the accompanying drawings as an example. However, changes may also be made as required, and all the changes fall within the protection scope of this application. The accompanying drawings in this application are only used to illustrate relative position relationships and do not represent an actual scale.

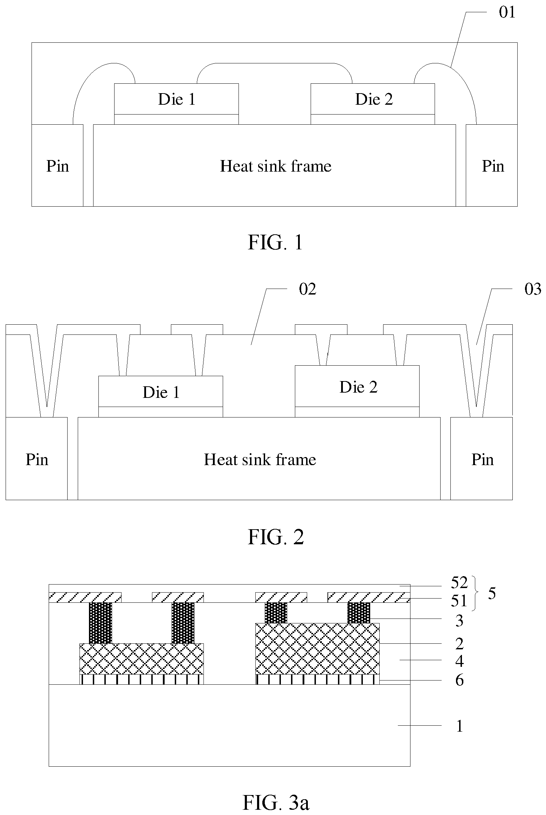

Refer to FIG. 1. An existing chip package solution is: Fasten a die (die) to a heat sink frame, implement a signal interconnection between dies and a signal interconnection between the die and a pin (pin) by a process of performing wire bonding (wire bonding) on a wire 01 (the wire may be specifically a gold wire or a copper wire), and then perform plastic packaging of a module, to form a system in package (sip, system in package) power amplifier module. A 5G power amplifier module continuously evolves toward a high frequency, high efficiency, and miniaturization. The foregoing package architecture using wire bonding is limited by a diameter of the wire (wire) and wiring. As a result, interconnection inductance in a chip package structure is relatively large. In addition, the wire in the chip package structure is relatively long. As a result, an insertion loss is large. This restricts evolution of a product toward miniaturization and high performance.

Refer to FIG. 2. Another vertical fan-out manner for chip package is: Fasten a die (die) to a heat sink frame and perform plastic packaging of a module, then provide a blind via 03 at a plastic package layer 02 by laser (laser) opening, and implement a signal interconnection between dies and a signal interconnection between the die and a pin by a process of performing copper plating on the blind via 03. An electroplating capability of the blind via 03 formed by laser opening is that a depth-to-thickness ratio of the blind via 03 is less than or equal to 1:1. This limits embedded integration of dies with different thicknesses. In addition, forming the blind via 03 by laser opening requires that a plating layer thickness of a pad (pad) of the die is at least 5 micrometers, a material of the pad is usually copper, and the die needs to be specially customized. This is not conducive to reducing manufacturing costs.

A chip package structure provided by embodiments of this application may be used in various electronic devices, such as a smartphone, a smart TV, a smart TV set top box, a personal computer (personal computer, PC), a wearable device, and a smart broadband. It should be noted that the chip package structure provided by embodiments of this application is intended to be used in electronic devices including but not limited to these and any other proper types of electronic devices. With reference to the accompanying drawings, the following describes in detail a chip package structure, a production method for the chip package structure, and an electronic device that are provided by this application.

FIG. 3a is a schematic diagram of a cross-sectional structure of an example of a chip package structure according to an embodiment of this application. Refer to FIG. 3a. In an embodiment of this application, the chip package structure may include: a first connection layer 1 having an upper surface and a lower surface that are opposite to each other, a die 2 disposed on the upper surface of the first connection layer 1, a first conduction structure 3 disposed on an upper surface of the die 2, a first plastic package layer 4 covering the die 2 and the first conduction structure 3, and a rewiring layer 5 disposed on the first plastic package layer 4. The die 2 is coupled to the upper surface of the first connection layer 1. The first conduction structure 3 is coupled to the die 2. At least a part of the first conduction structure 3 is exposed from an upper surface of the first plastic package layer 4, that is, the upper surface of the first plastic package layer 4 does not cover an upper end of the first conduction structure 3. The rewiring layer 5 is coupled to the first conduction structure 3. It should be noted that an upper surface of a component mentioned in this application is an upper surface of the component in a vertical direction, and a lower surface of a component mentioned in this application is a lower surface of the component in the vertical direction.

In the chip package structure provided by this embodiment of this application, a signal of the die 2 is directly led out through the first conduction structure 3 and the rewiring layer 5. This saves space, reduces a wiring length and interconnection inductance, and implements a low loss and an efficient interconnection of signals between dies 2. In addition, a signal interconnection between the dies 2 is implemented through the rewiring layer 5, and based on an impedance value of the die 2, circuit wiring matching the impedance value may be disposed at the rewiring layer. This does not need components used for coupling impedance, such as a capacitor, in the chip package structure, saves space, and reduces design complexity.

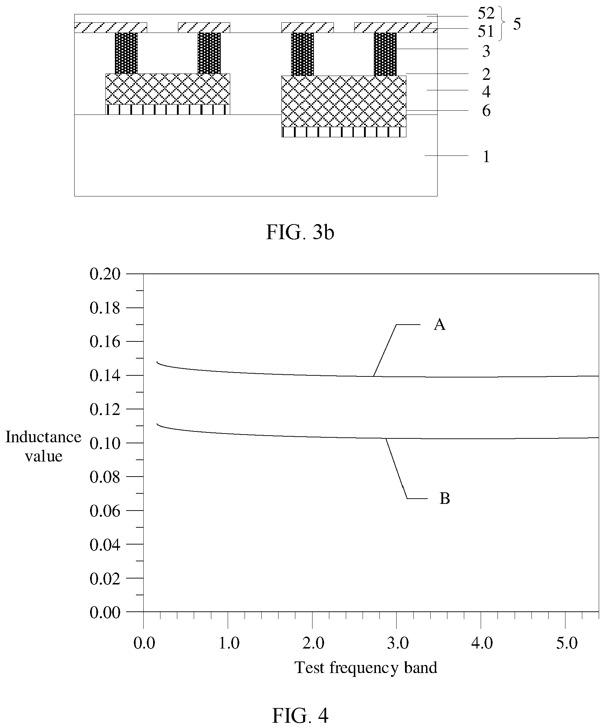

FIG. 4 is an example relationship between a test frequency band and an interconnection capacitance value of a chip package structure according to an embodiment of this application and the chip package structure shown in FIG. 1. Refer to FIG. 4. A is an interconnection inductance value obtained by testing the chip package structure shown in FIG. 1. B is an interconnection inductance value obtained by testing the chip package structure shown in this application. Compared with a manner of interconnection through the wire 01 in FIG. 1 in a conventional technology, a manner of leading out a signal through the first conduction structure 3 and the rewiring layer 5 in this application may reduce interconnection inductance by 20%, increase bandwidth by 25%, reduce a signal transmission loss, and improve power amplifier efficiency by 1% to 2%.

A die 2 (die) mentioned in this application is a die before a chip is packaged. Each die 2 is an unpackaged chip having an independent function, and may include one or more circuits. Specifically, the die 2 includes but is not limited to an application specific integrated circuit (application specific integrated circuit, ASIC), a memory die, an analog die, and the like. The die 2 is usually formed by a silicon substrate and a circuit layer disposed on the silicon substrate. A semiconductor device like a transistor and various functional circuits are usually formed at the circuit layer.

In this embodiment of this application, a plurality of dies 2 may be fastened to a first connection layer 1. A thickness of each die 2 is not limited. Still refer to FIG. 3a. Dies 2 with different thicknesses may be coupled to the first connection layer 1, that is, at least two dies 2 have different thicknesses. In this case, the finally formed chip package structure may be compatible with dies 2 of various sizes. The thickness of the die 2 may be 80 micrometers to 200 micrometers. Then, the first conduction structure 3 is formed on each of different dies 2. After plastic packaging is performed on the die 2 and the first conduction structure 3 as a whole to form a first plastic package layer 4, an end that is of the first conduction structure 3 and that is away from the die 2 is exposed by polishing (or by laser opening, or by polishing and laser opening). Then, a rewiring layer 5 coupled to the first conduction structure 3 is produced, to implement a signal interconnection between the dies 2 at the rewiring layer 5.

FIG. 3b is a schematic diagram of a cross-sectional structure of an example of another chip package structure according to an embodiment of this application. Refer to FIG. 3b. In an optional solution of this application, for dies 2 with different thicknesses, a corresponding sink structure may be disposed at a first connection layer 1. To be specific, for a die 2 with a relatively large thickness, a groove may be disposed at a corresponding position of the first connection layer 1, and the die 2 is disposed in the groove. A die 2 with a relatively small thickness may be directly coupled to an upper surface of the first connection layer 1. Alternatively, for the die 2 with the relatively small thickness, a protrusion may be disposed at a corresponding position of the first connection layer 1, and the die 2 is disposed on the protrusion. Finally, upper surfaces of the dies 2 with different thicknesses are as flush as possible. This can reduce a maximum thickness of the first conduction structure 3 located on each of the dies 2 with different thicknesses.

Still refer to FIG. 3a. In this embodiment of this application, a rewiring layer 5 may specifically include a patterned circuit layer 51 and a first protection layer 52 used to protect the patterned circuit layer 51. An impedance value of the patterned circuit layer 51 may match an impedance value of the die 2 coupled to the patterned circuit layer 51 through the first conduction structure 3. Matching between impedance values means that, for a preset impedance value of different dies 2, an impedance value that is approximately the same as the preset impedance value or in a tolerance range is specified for the patterned circuit layer 51. The impedance value may include parameters such as an inductive reactance value, a capacitive reactance value, and a resistance value. Specifically, the impedance value of the patterned circuit layer 51 may be adjusted to match the impedance value of the coupled die 2 by adjusting parameters such as a thickness of the patterned circuit layer 51 and an area of the patterned circuit layer 51. The first protection layer 52 may be green oil or a plastic package material. A thickness of the first protection layer is 10 micrometers to 40 micrometers.

In this embodiment of this application, the first connection layer 1 may be made of a metal-based or metal-inorganic composite material. A coefficient of thermal conductivity of the first connection layer 1 is 300 W/mk to 800 W/mk. A thickness of the first connection layer 1 may be 0.10 mm to 1.00 mm. The upper surface of the first connection layer 1 may have a first pin. The first pin has a heat sink and current flow function. The die 2 may be specifically coupled to the first pin. Still refer to FIG. 3a. The die 2 may be coupled to the first pin through a second connection layer 6. The second connection layer 6 may be made of a metal-based bonding material. A coefficient of thermal conductivity of the second connection layer 6 is 100 W/mk to 300 W/mk. A thickness of the second connection layer 6 may be 10 micrometers to 40 micrometers. During production, the die 2 may be bonded to the first pin through the second connection layer 6, and sintered and fastened by a sintering process. Alternatively, the die 2 may be directly coupled to the first pin. During production, a plating layer of the die 2 may be directly fused and fastened to the first pin by a eutectic soldering process instead of the sintering process. The eutectic soldering process usually needs to heat to 300 degrees Celsius to 500 degrees Celsius under a pressure condition. The sintering process usually needs to heat to about 200 degrees Celsius.

In this embodiment of this application, to implement high-density integration of a module, a first conduction structure 3 with a high thickness-to-diameter ratio (pillar) may be disposed. The high thickness-to-diameter ratio means that a ratio of a thickness of the first conduction structure to a diameter of the first conduction structure is 2:1 or above. To be specific, in the chip package structure, the thickness of at least some first conduction structures 3 is greater than or equal to twice the diameter of the first conduction structures. Based on a requirement of the chip package structure, the thickness-to-diameter ratio of some formed first conduction structures 3 may reach 10:1. This breaks through an electroplating capability limitation that a thickness ratio of a blind via formed by laser needs to be less than or equal to 1:1, and resolves a risk that a thin plating layer (less than 2 micrometers) of a die 2 in a power amplifier module may be penetrated by laser. For example, for a plurality of dies 2 with different thicknesses, a first conduction structure 3 with a relatively large thickness-to-diameter ratio may be formed on a die 2 with a relatively small thickness. A first conduction structure 3 with a relatively small thickness-to-diameter ratio may be formed on a die 2 with a relatively large thickness. Still refer to FIG. 3a. For example, a die 2 on a left side is relatively thick, and a die 2 on a right side is relatively thin. Therefore, a first conduction structure 3 with a high thickness-to-diameter ratio may be formed on the die 2 on the left side, and a first conduction structure 3 with a low thickness-to-diameter ratio may be formed on the die 2 on the right side. It should be noted that the diameter of the first conduction structure 3 is a diameter of any horizontal cross section of the first conduction structure 3 (if the horizontal cross section is circular) or a width of any horizontal cross section of the first conduction structure (if the horizontal cross section is polygonal).

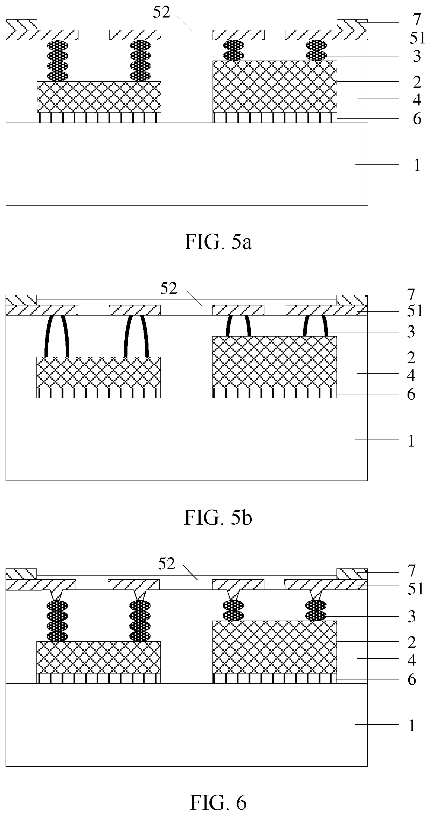

FIG. 5a is a schematic diagram of a cross-sectional structure of an example of another chip package structure according to an embodiment of this application. Refer to FIG. 5a. In this embodiment of this application, there are usually a plurality of first conduction structures 3 in the chip package structure. Any one of the first conduction structures 3 may be specifically a plurality of solder balls that are stacked in a vertical direction. During production, first conduction structures 3 with different heights may be formed on a die 2 by stacking solder balls by wire bonding. For example, one to five solder balls are stacked to form a first conduction structure 3 with a thickness between 50 micrometers and 250 micrometers. A thickness-to-diameter ratio of the formed first conduction structure 3 may be controlled by controlling a quantity of stacked solder balls. Generally, a relatively small quantity of solder balls may be stacked on a die 2 with a relatively large thickness. A relatively large quantity of solder balls may be stacked on a die 2 with a relatively small thickness. It should be noted that the thickness-to-diameter ratio of the first conduction structure 3 that includes the plurality of solder balls that are stacked is a ratio of a maximum thickness obtained after the solder balls are stacked to a maximum diameter of the solder balls.

FIG. 5b is a schematic diagram of a cross-sectional structure of an example of another chip package structure according to an embodiment of this application. Refer to FIG. 5b. Any first conduction structure 3 may alternatively be at least one wire. During production, a wire may be formed on a die 2 by wire bonding. The wire may be specifically a metal wire of 0.6 mil to 3.0 mil. A thickness-to-diameter ratio of a first conduction structure 3 formed by the wire is usually greater than 2: 1. It should be noted that the thickness-to-diameter ratio of the first conduction structure 3 including at least one wire is a ratio of a maximum length of all wires to a maximum diameter of all the wires, or a ratio of the maximum length of all the wires to a sum of diameters of all the wires. The first conduction structure 3 may be formed on different dies 2 in different manners or in a same manner. This is not limited herein.

Still refer to FIG. 5b. In this embodiment of this application, one first conduction structure 3 may include at least one pair of wires. During production, two ends of one initial wire may be coupled to a same die 2, that is, both ends of the initial wire are fastened to the same die 2. In this case, the initial wire forms an arc shape on the die 2. In the first conduction structure 3 finally formed by plastic packaging and polishing, the initial wire is divided into a pair of wires, and a top of the arc shape of the initial wire is broken and respectively used as exposed ends of two wires. That both ends of the initial wire are fastened to one die 2 helps stabilize a shape of the first conduction structure 3 when a first plastic package layer 4 is subsequently formed. Alternatively, in another embodiment of this application, only one end of the initial wire may be coupled to the die 2. The other end is suspended as an exposed end of the first conduction structure 3.

Still refer to FIG. 5a and FIG. 5b. In this embodiment of this application, after the first conduction structure 3 is formed on the die 2, plastic packaging may be performed on the die 2 and the first conduction structure 3, to form the first plastic package layer 4 with a thickness of about 400 micrometers. This ensures that the die 2 and the first conduction structure 3 form embedded structures in the first plastic package layer 4. Then, an upper surface of the first plastic package layer 4 may be polished by using a high-precision polishing device. For example, a thickness of the polished first plastic package layer 4 may be 280±10 micrometers, to expose an end of the first conduction structure 3. The upper surface of the first plastic package layer 4 formed by this process is flush with the exposed end of the first conduction structure 3. FIG. 6 is a schematic diagram of a cross-sectional structure of an example of another chip package structure according to an embodiment of this application. Alternatively, an upper surface of the first plastic package layer 4 may be polished by using a high-precision polishing device, and then an end of the first conduction structure 3 is exposed by laser opening. Refer to FIG. 6. The first plastic package layer 4 formed by this process has through grooves that expose the end of the first conduction structure 3. A rewiring layer 5 has protruding parts that are in a one-to-one correspondence with the through grooves. The protruding part may be located in the through groove, so that the first conduction structure 3 is coupled. Alternatively, an end of the first conduction structure 3 may be exposed directly by laser opening. Still refer to FIG. 6. The first plastic package layer 4 formed by this process has through grooves that expose the end of the first conduction structure 3. A rewiring layer 5 has protruding parts that are in a one-to-one correspondence with the through grooves. The protruding part may be located in the through groove, so that the first conduction structure 3 is coupled.

Still refer to FIG. 5a, FIG. 5b, and FIG. 6. In this embodiment of this application, when the chip package structure is used in a flip package structure, a connection terminal 7 may be further disposed on the rewiring layer 5. The connection terminal 7 is configured to be coupled to an external circuit board. The connection terminal 7 may be specifically soldering tin, a solder ball, a solderable plating layer, or a solderable connection column.

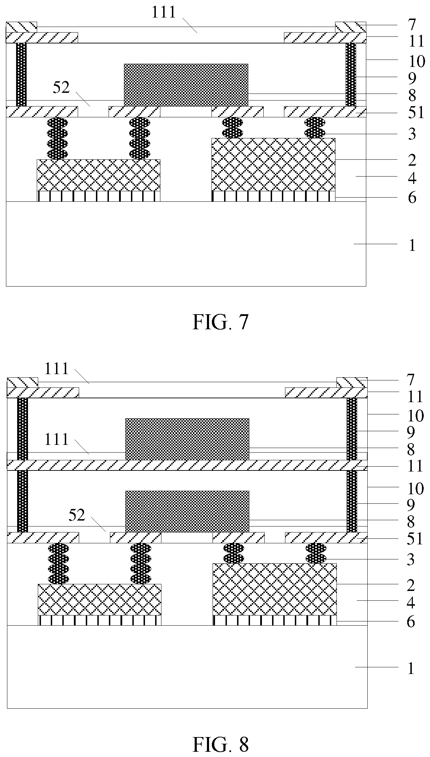

FIG. 7 is a schematic diagram of a cross-sectional structure of an example of another chip package structure according to an embodiment of this application. In another embodiment of this application, to implement three dimensional (3D, three dimensional) stacking and high-density integration, another chip may be further disposed on a rewiring layer 5. Refer to FIG. 7. In this embodiment of this application, the chip package structure may further include: a chip 8 disposed on the rewiring layer 5, a second conduction structure 9 disposed on the rewiring layer 5, a second plastic package layer 10 covering the chip 8 and the second conduction structure 9, a third connection layer 11 disposed on the second plastic package layer 10, and a second protection layer 111 configured to protect the third connection layer 11. The second protection layer 111 may be the green oil or a plastic package material. A thickness of the second protection layer 111 is 10 micrometers to 40 micrometers. At least a part of the second conduction structure 9 is exposed from an upper surface of the second plastic package layer 10. The third connection layer 11 is coupled to the second conduction structure 9. A signal of the chip 8 may be led out through the rewiring layer 5, the second conduction structure 9, and the third connection layer 11, to implement a vertical interconnection. It should be noted that the vertical interconnection mentioned in this application means that an electrical connection is implemented in a vertical direction (a thickness direction of the chip 8).

FIG. 8 is a schematic diagram of a cross-sectional structure of an example of another chip package structure according to an embodiment of this application. In this embodiment of this application, a chip 8, a second conduction structure 9, a second plastic package layer 10, a third connection layer 11, and a second protection layer 111 may be considered to form a layer of stackup. The chip package structure may include at least one layer of stackup. Still refer to FIG. 7. Only one layer of stackup may be disposed in the chip package structure. When the chip package structure is used in a flip package structure, a connection terminal 7 may be further disposed at the third connection layer 11. The connection terminal 7 is configured to be coupled to an external circuit board. The connection terminal 7 may be specifically soldering tin, a solder ball, a solderable plating layer, or a solderable connection column. Alternatively, refer to FIG. 8. In another embodiment of this application, a plurality of layers of stackups may be disposed in the chip package structure. A chip 8 in a stackup of a bottom layer is coupled to a rewiring layer 5. A chip 8 in a stackup of another layer is coupled to a third connection layer 11 in a stackup of a next layer. When the chip package structure is used in a flip package structure, a connection terminal 7 may be further disposed at a third connection layer 11 in a stackup of a top layer. The connection terminal 7 is configured to be coupled to an external circuit board. The connection terminal 7 may be specifically soldering tin, a solder ball, a solderable plating layer, or a solderable connection column.

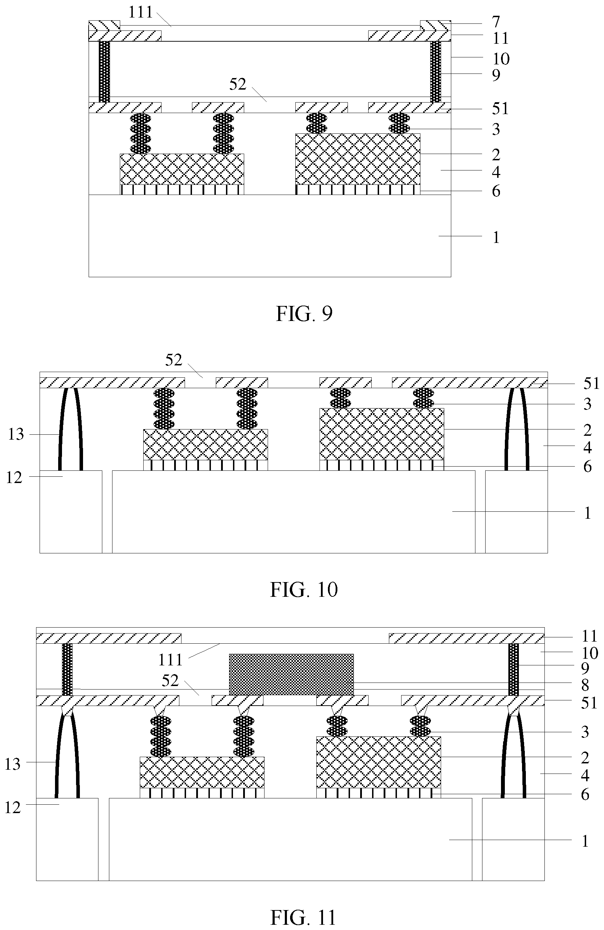

FIG. 9 is a schematic diagram of a cross-sectional structure of an example of another chip package structure according to an embodiment of this application. Refer to FIG. 7 and FIG. 8. The stackup of each layer may include at least one chip 8. The chip 8 may be of different types, for example, a chip-type resistor, capacitor, and inductor, and a control-type IC. Refer to FIG. 9. In an optional solution, components such as a second conduction structure 9, a second plastic package layer 10, and a third connection layer 11 instead of the chip 8 may be disposed in any one of the foregoing stackups. The stackup may prevent signal interference.

In this embodiment of this application, the second conduction structure 9 may be specifically a plurality of solder balls that are stacked in a vertical direction, or at least one wire, or a planted pin. Specifically, the plurality of solder balls that are stacked or the at least one wire may be formed by wire bonding, and the planted pin is formed by soldering. To implement high-density integration of a module, similar to a first conduction structure 3, a second conduction structure 9 with a high thickness-to-diameter ratio may also be disposed. In addition, for parameter settings and a specific production manner of the second conduction structure 9, refer to the first conduction structure 3. Details are not described herein again.

FIG. 10 is a schematic diagram of a cross-sectional structure of an example of another chip package structure according to an embodiment of this application. In another embodiment of this application, to lead out a signal of the chip package structure from both sides, that is, lead out the signal from a side of a lower surface of a first connection layer 1, the first connection layer 1 may have a second pin 12. The second pin 12 may also be referred to as an external pin. Refer to FIG. 10. A third conduction structure 13 may be disposed on the second pin 12. The third conduction structure 13 and a first conduction structure 3 may be simultaneously formed. A first plastic package layer 4 covers the third conduction structure 13. At least a part of the third conduction structure 13 is exposed from an upper surface of the first plastic package layer 4. In this case, a rewiring layer 5 is coupled to the second pin 12 of the first connection layer 1 through the third conduction structure 13, and a signal of a die 2 may flow to the lower surface of the first connection layer 1 through the first conduction structure 3, the rewiring layer 5, a second conduction structure 9, and the first connection layer 1, and then led out.

In this embodiment of this application, to implement high-density integration of a module, similar to the first conduction structure 3, a third conduction structure 13 with a high thickness-to-diameter ratio may be disposed. Based on a requirement of the chip package structure, the thickness-to-diameter ratio of the formed third conduction structure 13 may reach 10: 1. This breaks through an electroplating capability limitation that a thickness ratio of a blind via formed by laser needs to be less than or equal to 1:1, and resolves a risk that a thin plating layer (less than 2 micrometers) in a power amplifier module may be penetrated by laser.

In this embodiment of this application, the third conduction structure 13 may be specifically a plurality of solder balls that are stacked in a vertical direction, or at least one wire, or a planted pin. Specifically, the stacked solder balls or the wire may be formed on the second pin 12 by wire bonding, or the planted pin is formed by soldering. An upper surface of the third conduction structure 13 needs to be as flush as possible with an upper surface of the first conduction structure 3. To be specific, when the third conduction structure 13 is formed, refer to a sum of thicknesses of the first conduction structure 3 and the die 2. For example, a wire of 340±20 micrometers may be formed as the third conduction structure 13. In FIG. 10, only an example in which the third conduction structure 13 includes a pair of wires is used. In an actual product, specific compositions of the first conduction structure 3 and the third conduction structure 13 may be mutually combined.

Similarly, in this embodiment of this application, one third conduction structure 13 may include at least one pair of wires. During production, two ends of one initial wire may be coupled to a same second pin 12, that is, both ends of the initial wire are fastened to the same second pin 12. In this case, the initial wire forms an arc shape on the second pin 12. In the third conduction structure 13 finally formed by plastic packaging and polishing, the initial wire is divided into a pair of wires, and a top of the arc shape of the initial wire is broken and respectively used as exposed ends of two wires. That both ends of the initial wire are fastened to one second pin 12 helps stabilize a shape of the third conduction structure 13 when the first plastic package layer 4 is subsequently formed. Alternatively, in another embodiment of this application, only one end of the initial wire may be coupled to the second pin 12. The other end is suspended as the exposed end of the third conduction structure 13.

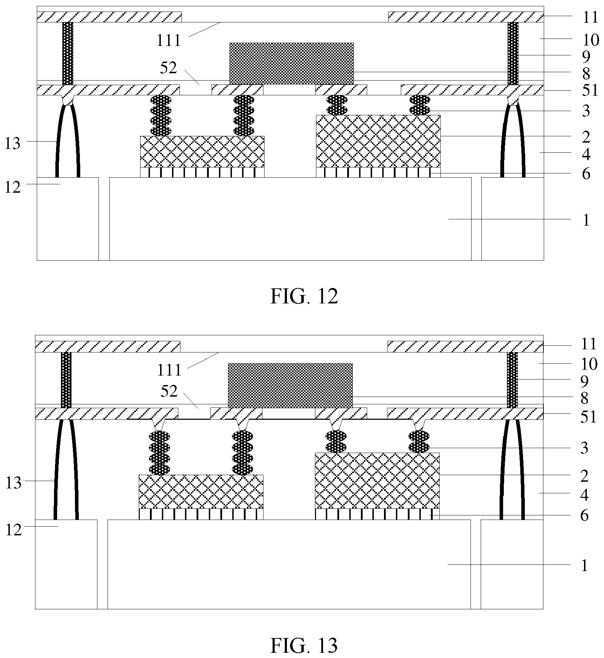

FIG. 11 is a schematic diagram of a cross-sectional structure of an example of another chip package structure according to an embodiment of this application. FIG. 12 is a schematic diagram of a cross-sectional structure of an example of another chip package structure according to an embodiment of this application. FIG. 13 is a schematic diagram of a cross-sectional structure of an example of another chip package structure according to an embodiment of this application. In this embodiment of this application, after a first conduction structure 3 is formed on a die 2 and a third conduction structure 13 is formed on a second pin 12, plastic packaging may be performed on the die 2, the first conduction structure 3, and the third conduction structure 13 to form a first plastic package layer 4 with a thickness of about 400 micrometers. This ensures that the die 2, the first conduction structure 3, and the third conduction structure 13 simultaneously form embedded structures in the first plastic package layer 4. Then, an upper surface of the first plastic package layer 4 may be polished by using a high-precision polishing device. For example, a thickness of the polished first plastic package layer 4 may be 280±10 micrometers, to expose an end of the first conduction structure 3 and an end of the third conduction structure 13. Refer to FIG. 10. The upper surface of the first plastic package layer 4 formed by this process is flush with the exposed end of the first conduction structure 3 and the exposed end of the third conduction structure 13. Alternatively, an end of the first conduction structure 3 and an end of the third conduction structure 13 may be directly exposed by laser opening. Refer to FIG. 11. The first plastic package layer 4 formed by this process has through grooves that expose the end of the first conduction structure 3 and the end of the third conduction structure 13. A rewiring layer 5 has protruding parts that are in a one-to-one correspondence with the through grooves. The protruding part is located in the through groove. Alternatively, an upper surface of the first plastic package layer 4 may be polished by using a high-precision polishing device, and then an end of the first conduction structure 3 and an end of the third conduction structure 13 are exposed by laser opening. Refer to FIG. 11. The first plastic package layer 4 formed by this process has through grooves that expose the end of the first conduction structure 3 and the end of the third conduction structure 13. A rewiring layer has protruding parts that are in a one-to-one correspondence with the through grooves. The protruding part is located in the through groove. Alternatively, when an end of the first conduction structure 3 is higher than an end of the third conduction structure 13, an upper surface of the first plastic package layer 4 may be polished by using a high-precision polishing device until the end of the first conduction structure 3 is exposed, and then the end of the third conduction structure 13 is exposed by laser opening. Refer to FIG. 12. An upper surface of the first plastic package layer 4 formed by this process is flush with the exposed end of the first conduction structure 3. In addition, the first plastic package layer 4 has through grooves that expose the end of the third conduction structure 13. A rewiring layer 5 has protruding parts that are in a one-to-one correspondence with the through grooves. The protruding part is located in the through groove. When an end of the third conduction structure 13 is higher than an end of the first conduction structure 3, an upper surface of the first plastic package layer 4 may be polished by using a high-precision polishing device until the end of the third conduction structure 13 is exposed, and then the end of the first conduction structure 3 is exposed by laser opening. Refer to FIG. 13. An upper surface of the first plastic package layer 4 formed by this process is flush with the exposed end of the third conduction structure 13. In addition, the first plastic package layer 4 has through grooves that expose the end of the first conduction structure 3. A rewiring layer 5 has protruding parts that are in a one-to-one correspondence with the through grooves. The protruding part is located in the through groove.

Based on a same technical concept, this application further provides a production method for a chip package structure. A problem-resolving principle of the production method is similar to that of the foregoing chip package structure. Therefore, for implementation of the production method, refer to the implementation of the foregoing chip package structure. Repeated description is not provided.

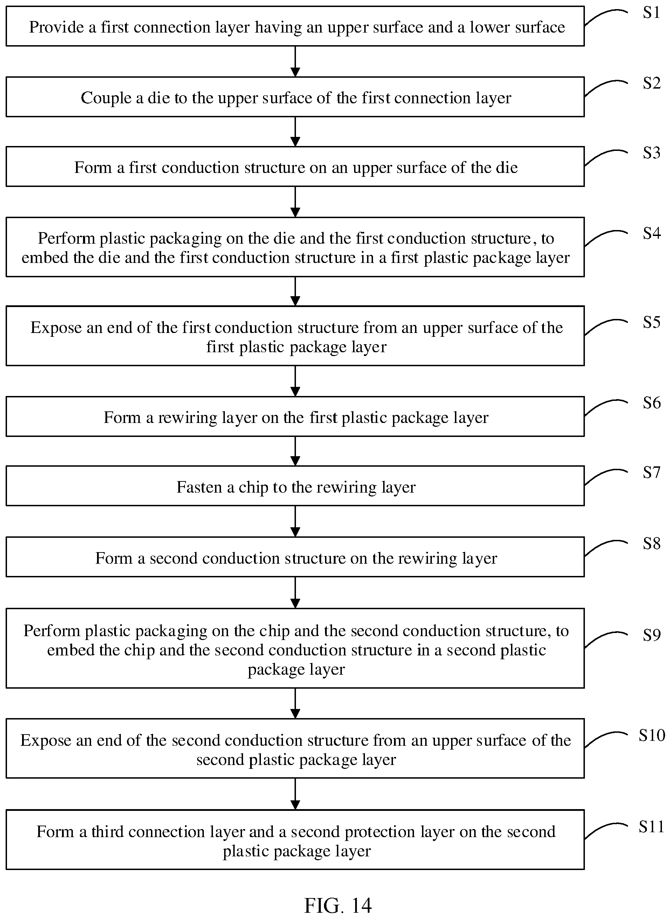

FIG. 14 is a schematic flowchart of an example of a production method for a chip package structure according to an embodiment of this application. Refer to FIG. 14. The production method mainly includes the following steps.

S 1: Provide a first connection layer 1 having an upper surface and a lower surface.

S2: Couple and fasten a die 2 to the upper surface of the first connection layer 1.

Specifically, the die 2 may be bonded to the first connection layer 1 through a second connection layer 6, and a sintering process is performed, to fasten the die 2 to the first connection layer 1. Alternatively, the die 2 may be fastened to the first connection layer 1 by a eutectic soldering process.

S3: Form a first conduction structure 3 on an upper surface of the die 2.

Specifically, a plurality of solder balls that are stacked in a vertical direction may be formed on the die 2 by a wire bonding process. Alternatively, a wire is formed on the die 2 by a wire bonding process, where one end of the wire is coupled to the die 2, or both ends of the wire are coupled to the die 2.

In an optional solution, if the upper surface of the first connection layer 1 has a second pin 12, namely an external pin, when forming the first conduction structure 3 on the die 2, the production method may further include: Form a third conduction structure 13 on the second pin 12. Specifically, a plurality of solder balls that are stacked in the vertical direction may be formed on the second pin 12 by the wire bonding process. Alternatively, a wire is formed on the second pin 12 by the wire bonding process, where one end of the wire is coupled to the second pin 12, or both ends of the wire are coupled to the second pin 12. Alternatively, a planted pin is formed on the second pin 12 by soldering.

S4: Perform plastic packaging on the die 2 and the first conduction structure 3, to embed the die 2 and the first conduction structure 3 in a first plastic package layer 4.

In an optional solution, when performing plastic packaging on the die 2 and the first conduction structure 3, to embed the die 2 and the first conduction structure 3 in the first plastic package layer 4, the method may further include: Perform plastic packaging on the third conduction structure 13, to embed the third conduction structure 13 in the first plastic package layer 4.

S5: Expose an end of the first conduction structure 3 from an upper surface of the first plastic package layer 4.

Specifically, the end of the first conduction structure 3 may be exposed from the upper surface of the first plastic package layer 4 by polishing. Alternatively, the end of the first conduction structure 3 may be exposed from the upper surface of the first plastic package layer 4 by laser opening.

In an optional solution, when exposing the end of the first conduction structure 3 from the upper surface of the first plastic package layer 4, the production method further includes: Expose an end of the third conduction structure 13 from the upper surface of the plastic package layer.

Specifically, the end of the third conduction structure 13 may be exposed from the upper surface of the first plastic package layer 4 by polishing. Alternatively, the end of the third conduction structure 13 is exposed from the upper surface of the first plastic package layer 4 by laser opening.

S6: Form a rewiring layer 5 on the first plastic package layer 4. Specifically, a patterned circuit layer 51 and a first protection layer 52 configured to protect the patterned circuit layer 51 may be formed.

In an optional solution, a connection terminal 7 may be further formed on the rewiring layer 5. The connection terminal 7 is configured to be coupled to an external circuit board.

In an optional solution, still refer to FIG. 14. In this embodiment of this application, the production method may further include the following steps.

S7: Fasten a chip 8 to the rewiring layer 5.

S8: Form a second conduction structure 9 on the rewiring layer 5.

In an optional solution, a plurality of solder balls that are stacked in the vertical direction may be formed on the rewiring layer 5 by the wire bonding process. In another optional solution, a wire may be formed on the rewiring layer 5 by the wire bonding process, where one end of the wire is coupled to the rewiring layer 5, or both ends of the wire are coupled to the rewiring layer 5. In another optional solution, a planted pin is formed on the rewiring layer 5 by soldering.

S9: Perform plastic packaging on the chip 8 and the second conduction structure 9, to embed the chip 8 and the second conduction structure 9 in a second plastic package layer 10.

S10: Expose an end of the second conduction structure 9 from an upper surface of the second plastic package layer 10.

S11: Form a third connection layer 11 and a second protection layer 111 on the second plastic package layer 10.

In an optional solution, a connection terminal 7 may be further formed on the third connection layer 11. The connection terminal 7 is configured to be coupled to the external circuit board.

Based on a same technical concept, this application further provides an electronic device. The electronic device includes a circuit board and the chip package structure in any one of the foregoing technical solutions or the chip package structure produced by any production method that is electrically interconnected with the circuit board. The electronic device provided by embodiments of this application includes but is not limited to a smartphone, a smart TV, a smart TV set top box, a personal computer (personal computer, PC), a wearable device, a smart broadband, and the like, which are not enumerated herein. A problem-resolving principle of the electronic device is similar to that of the foregoing chip package structure and production method. Therefore, for implementation of the electronic device, refer to the implementation of the foregoing chip package structure and production method. Repeated description is not provided.

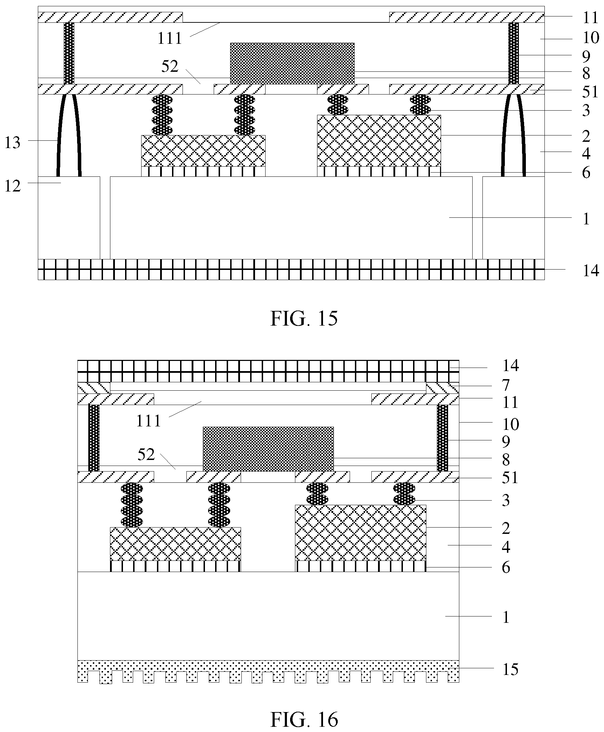

FIG. 15 is a schematic diagram of a cross-sectional structure of an example of an electronic device according to an embodiment of this application. Refer to FIG. 15. In this embodiment of this application, when a third conduction structure 13 is disposed in a chip package structure, the chip package structure may be a surface-mounted structure. A circuit board 14 may be disposed on a lower surface of a first connection layer 1 in the chip package structure.

FIG. 16 is a schematic diagram of a cross-sectional structure of an example of another electronic device according to an embodiment of this application. Refer to FIG. 16. In another embodiment of this application, when a connection terminal 7 is disposed in a chip package structure, the chip package structure may be a flip structure. A circuit board 14 may be disposed on the chip package structure and coupled to the connection terminal 7. In this case, a heat dissipation structure 15 may be further disposed on a lower surface of a first connection layer 1 in the chip package structure.

It is clear that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A chip package structure, comprising:
a first connection layer, having an upper surface and a lower surface that are opposite to each other;
a die, disposed on the upper surface of the first connection layer and coupled to the first connection layer;
a first conduction structure, disposed on an upper surface of the die and coupled to the die;
a first plastic package layer, covering the die and the first conduction structure, wherein at least a part of the first conduction structure is exposed from an upper surface of the first plastic package layer; and
a rewiring layer, disposed on the first plastic package layer, and coupled to the first conduction structure.

2. The chip package structure according to claim 1, wherein the rewiring layer comprises a patterned circuit layer and a first protection layer configured to protect the patterned circuit layer, and an impedance value of the patterned circuit layer matches an impedance value of a die coupled to the patterned circuit layer through the first conduction structure.

3. The chip package structure according to claim 1 or 2, wherein there are a plurality of first conduction structures, and at least one of the plurality of first conduction structures is a plurality of solder balls that are stacked in a vertical direction.

4. The chip package structure according to claim 1 or 2, wherein there are a plurality of first conduction structures, and at least one of the plurality of first conduction structures comprises at least one wire.

5. The chip package structure according to any one of claims 1 to 4, wherein a thickness of the first conduction structure in the vertical direction is greater than or equal to twice a diameter.

6. The chip package structure according to any one of claims 1 to 5, wherein the upper surface of the first plastic package layer is flush with an exposed end of the first conduction structure.

7. The chip package structure according to any one of claims 1 to 5, wherein the first plastic package layer has through grooves that expose an end of the first conduction structure, and the rewiring layer has protruding parts that are in a one-to-one correspondence with the through grooves.

8. The chip package structure according to any one of claims 1 to 7, wherein there are a plurality of dies, and at least two dies have different thicknesses in the vertical direction.

9. The chip package structure according to any one of claims 1 to 8, wherein the die is coupled to the upper surface of the first connection layer through a second connection layer; or the die is directly coupled to the upper surface of the first connection layer.

10. The chip package structure according to any one of claims 1 to 9, further comprising:
a connection terminal, disposed on the rewiring layer, and configured to be coupled to a circuit board.

11. The chip package structure according to any one of claims 1 to 9, further comprising:
a chip, disposed on the rewiring layer;
a second conduction structure, disposed on the rewiring layer;
a second plastic package layer, covering the chip and the second conduction structure, wherein at least a part of the second conduction structure is exposed from an upper surface of the second plastic package layer;
a third connection layer, disposed on the second plastic package layer, and coupled to the second conduction structure; and
a second protection layer, configured to protect the third connection layer.

12. The chip package structure according to claim 11, wherein at least one second conduction structure is a plurality of solder balls that are stacked in the vertical direction, or at least one wire, or a planted pin.

13. The chip package structure according to claim 12, further comprising a connection terminal, disposed on the third connection layer, and configured to be coupled to a circuit board.

14. The chip package structure according to any one of claims 1 to 9 and 11 to 12, wherein the first connection layer has an external pin; and the chip package structure further comprises a third conduction structure disposed on the external pin, wherein the first plastic package layer covers the third conduction structure, at least a part of the third conduction structure is exposed from the upper surface of the first plastic package layer, and the rewiring layer is coupled to the third conduction structure.

15. The chip package structure according to claim 14, wherein at least one third conduction structure is a plurality of solder balls that are stacked in the vertical direction, or at least one wire, or a planted pin.

16. The chip package structure according to claim 14 or 15, wherein the upper surface of the first plastic package layer is flush with an exposed end of the third conduction structure.

17. The chip package structure according to claim 14 or 15, wherein the first plastic package layer has through grooves that expose an end of the third conduction structure, and the rewiring layer has protruding parts that are in a one-to-one correspondence with the through grooves.

18. A production method for a chip package structure, comprising:
providing a first connection layer having an upper surface and a lower surface that are opposite to each other;
coupling a die to the upper surface of the first connection layer;
forming a first conduction structure on an upper surface of the die;
performing plastic packaging on the die and the first conduction structure, to embed the die and the first conduction structure in a first plastic package layer;
exposing an end of the first conduction structure from an upper surface of the first plastic package layer; and
forming a rewiring layer on the first plastic package layer.

19. The production method according to claim 18, wherein the coupling a die to the upper surface of the first connection layer comprises:
bonding the die to the first connection layer through a second connection layer, and performing a sintering process; or
fastening the die to the first connection layer by a eutectic soldering process.

20. The production method according to claim 18 or 19, wherein the forming a first conduction structure on an upper surface of the die comprises:
forming, by a wire bonding process and on the upper surface of the die, a plurality of solder balls that are stacked in a vertical direction.

21. The production method according to claim 18 or 19, wherein the forming a first conduction structure on an upper surface of the die comprises:
forming, by a wire bonding process, a wire on the upper surface of the die, wherein one end of the wire is coupled to the die, or both ends of the wire are coupled to the die.

22. The production method according to any one of claims 18 to 21, wherein the exposing an end of the first conduction structure from an upper surface of the first plastic package layer comprises:
exposing the end of the first conduction structure from the upper surface of the first plastic package layer by polishing; or
exposing the end of the first conduction structure from the upper surface of the first plastic package layer by laser opening.

23. The production method according to any one of claims 18 to 22, further comprising:
fastening a chip to the rewiring layer;
forming a second conduction structure on the rewiring layer;
performing plastic packaging on the chip and the second conduction structure, to embed the chip and the second conduction structure in a second plastic package layer;
exposing an end of the second conduction structure from an upper surface of the second plastic package layer; and
forming a third connection layer and a second protection layer on the second plastic package layer.

24. The production method according to claim 23, wherein the forming a second conduction structure on the rewiring layer comprises:
forming, by the wire bonding process and on the rewiring layer, a plurality of solder balls that are stacked in the vertical direction; or
forming a wire on the rewiring layer by the wire bonding process, wherein one end of the wire is coupled to the rewiring layer, or both ends of the wire are coupled to the rewiring layer; or
forming a planted pin on the rewiring layer by soldering.

25. The production method according to any one of claims 18 to 24, wherein the first connection layer has an external pin; when forming the first conduction structure on the upper surface of the die, the production method further comprises: forming a third conduction structure on the external pin;
when performing plastic packaging on the die and the first conduction structure, to embed the die and the first conduction structure in the first plastic package layer, the production method further comprises: performing plastic packaging on the third conduction structure, to embed the third conduction structure in the first plastic package layer; and
when exposing the end of the first conduction structure from the upper surface of the first plastic package layer, the production method further comprises: exposing an end of the third conduction structure from the upper surface of the plastic package layer.

26. The production method according to claim 25, wherein the forming a third conduction structure on the external pin comprises:
forming, by the wire bonding process and on the external pin, a plurality of solder balls that are stacked in the vertical direction; or
forming a wire on the external pin by the wire bonding process, wherein one end of the wire is coupled to the external pin, or both ends of the wire are coupled to the external pin; or
forming a planted pin on the external pin by soldering.

27. An electronic device, comprising: the chip package structure according to any one of claims 1 to 17 or a chip package structure produced by the production method according to any one of claims 18 to 26, and a circuit board electrically interconnected with the chip package structure.

28. The electronic device according to claim 27, wherein when the chip package structure comprises a connection terminal, the circuit board is disposed on an upper surface of the chip package structure and is coupled to the connection terminal; and
the electronic device further comprises a heat dissipation structure, disposed on a lower surface of a first connection layer in the chip package structure.

29. The electronic device according to claim 27, wherein when the chip package structure comprises a third conduction structure, the circuit board is disposed on a lower surface of a first connection layer in the chip package structure.
